# EUROPEAN PATENT SPECIFICATION

(11) **EP 0 729 622 B1**
(45) Date of publication and mention of the grant of the patent: **18.04.2001**
(21) Application number: 94932025.3
(22) Date of filing: 24.10.1994
(51) Int. Cl.: G06K 19/077, H05K 5/02

(54) **IC CARD WITH BOARD POSITIONING MEANS**
IC-KARTE MIT TRÄGEREINSTELLUNGSMITTELN
CARTE A CIRCUIT IMPRIME COMPORTANT DES MOYENS DE POSITIONNEMENT DE LA CARTE

(30) Priority: 18.11.1993 US 154318; 25.02.1994 US 201983
(43) Date of publication of application: 04.09.1996
(73) Proprietor: ITT MANUFACTURING ENTERPRISES, INC., Wilmington, Delaware 19801 (US)
(72) Inventor: BETHURUM, Gary, Cain, Laguna Niguel, CA 92677 (US)
(74) Representative: Esser, Wolfgang
(86) International application number: US9412224
(87) International publication number: WO9514288

(56) References cited:
- EP-A- 0 546 680
- EP-A- 0 648 894
- US-A- 4 924 076
- US-A- 5 242 310

## Description

### BACKGROUND OF THE INVENTION:

IC cards, which are often memory cards, are commonly constructed with a molded plastic housing having a plurality of housing parts. Under JEIDA standards, each IC card has a card length of *85.6mm (3.370 inch),* a card width of *54mm (2.126 inch),* and a card thickness of *4.8mm (0.190 inch).* Accordingly, there is little vertical space between top and bottom surfaces of a circuit board lying in the housing, and top or bottom cover portions of the card. If the vertical height of the circuit board could be changed, a designer could leave about equal spaces at both surfaces of the circuit board to place a maximum number of thin components on both board surfaces. Alternatively, the designer could maximize the space on one board surface to accommodate thicker components on that surface, at the expense of eliminating moderately thick components on the other surface. If such choice could be made by the circuit board manufacturer who assembles the IC card, with the other components unchanged from a "standard" design, this would increase design choices for the circuit board manufacturer.

Examples of IC cards are shown in EP-A-0 546 680 and US-A-5 242 310.

### SUMMARY OF THE INVENTION

The features of the invention are set forth in the appended claims. The above prior art is reflected by the preambles of claims 1, 5, 8 and 10.

In accordance with one embodiment of the present invention, an IC card is provided that is of low cost and which facilitates selection of circuit board height. The IC card includes a housing *and* a *circuit board assembly lying in said housing. Said housing includes upper and lower housing portions, with the lower housing portion including a plurality of of primarily upwardly-facing board-supporting surfaces lying substantially in each of at least two vertically-spacesd horizontal planes, to enable support of a circuit board lower face in a selected one of said horizontal planes.* Each platform carries an upwardly projecting step, and the circuit board has a plurality of apertures that each receives one of the steps. In one card, the housing includes lower and upper housing halves that form lower and upper cover portions and at least part of each vertical side of the housing. The housing halves each have a plurality of platforms at each side, with each side of the circuit board trapped between the platforms of the two housing halves.

In another card, the housing includes forward and rearward housing connector parts with at least the forward housing connector part having a laterally-extending row of contacts that engage corresponding contact pads on the circuit board. Each housing connector part also has peg-like platform steps lying laterally beyond opposite ends of the row of contacts. *The peg having at least two steps and primarily upwardly-facing board-supporting surfaces at the bottom of each step, with each board-supporting surface lying substantially in one of at least two vertically-spaced horizontal planes, to enable support of the circuit board front end in a selected one of said horizontal planes.* Each circuit board end portion has apertures at its opposite sides which receive corresponding peg-like steps.

The invention will be best understood from the following description when read in conjunction with the accompanying drawings.

### BRIEF DESCRIPTION OF THE DRAWINGS

- FIG. 1: is an isometric view of an IC card and an electronic device in the form of a lap top computer, constructed in accordance with the present invention.
- FIG. 2: is an exploded isometric view of the IC card of FIG. 1.
- FIG. 3: is an exploded isometric view of sections of a side portion of the lower and upper housing halves, and also showing three different embodiments of a circuit board which can be mounted on the housing halves.
- FIG. 4: is a partial isometric view of a portion of the lower housing half and one of the circuit boards of FIG. 3, shown assembled.
- FIG. 5: is a partial sectional view taken on the line 5 - 5 of FIG. 1.
- FIG. 6: is a partial sectional view taken on the line 6 - 6 of FIG. 1.
- FIG. 7: is an enlarged view of a portion of FIG. 5.
- FIG. 8: is an isometric view of an IC card of another embodiment of the invention.
- FIG. 9: is an exploded isometric view of the IC card of FIG. 8.
- FIG. 10: is a partial exploded view of the IC card of FIG. 9.
- FIG. 11: is a partial sectional view taken on line 11-11 of FIG. 10, showing the parts in an assembled position, and showing two other circuit boards in phantom lines.
- FIG. 12: is a partial sectional view of the IC card of FIG. 9.

### DESCRIPTION OF THE PREFERRED EMBODIMENTS

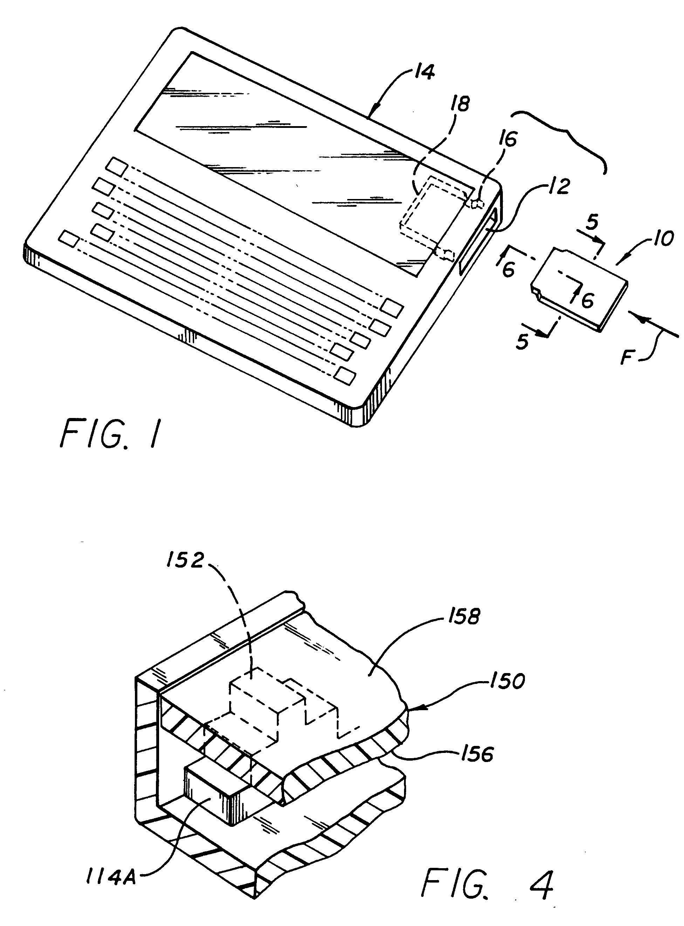

FIG. 1 illustrates an lC (integrated circuit) card 10 of the present invention, that can be inserted in a forward direction F into a slot 12 of a thin electronic device 14. When the card is inserted, a pair of grounding contacts 16 wipe the opposite sides of the card to discharge any static electricity.

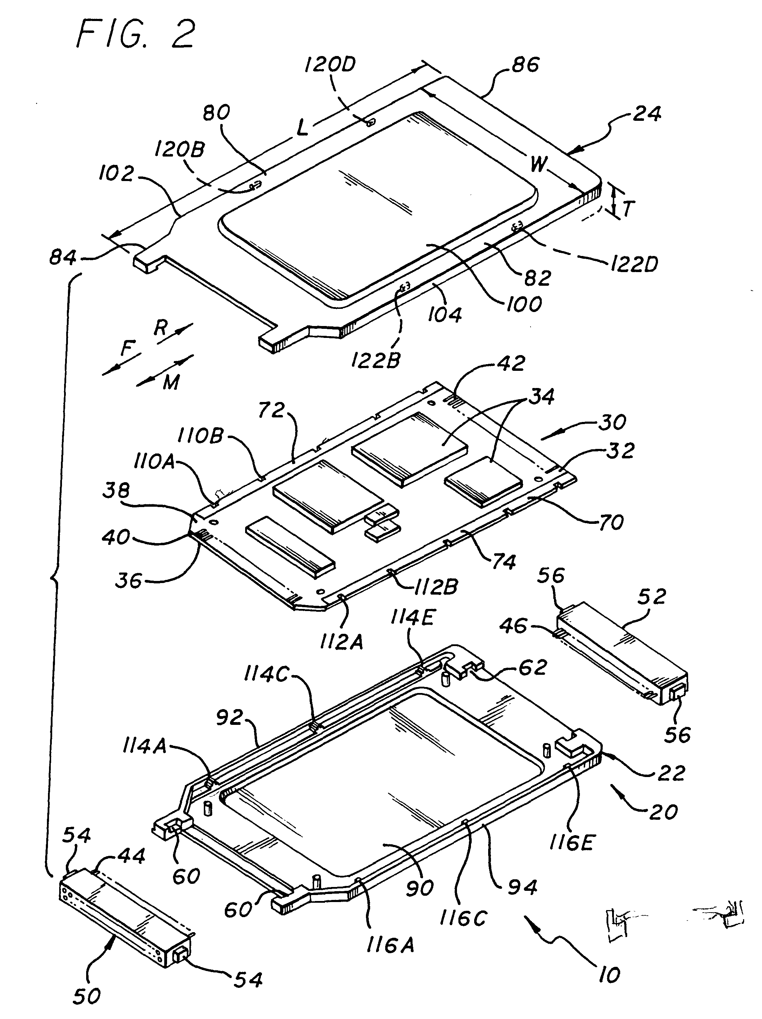

As shown in FIG. 2, the IC card 10 includes a housing 20 having first and second or lower and upper housing parts or halves 22, 24. A circuit board assembly 30 which lies within the housing, includes a circuit board 32 and active components 34 such as integrated circuit "chips", capacitors, and resistors, in addition to passive components (conductive traces, wires, etc.). The circuit board has lower and upper faces or surfaces 36, 38 and the components can be mounted on both surfaces. The housing also includes front and rear connector frames or parts 50, 52 that hold rows of contacts. The circuit board has rows 40, 42 of conductive pads at its opposite ends which are soldered to contact tails 44, 46 of contacts that lie in the connector housing parts.

The IC card is assembled by first placing the connector housing parts 50, 52 so the contact tails 44, 46 lie on the rows of contact pads 40, 42 of the circuit board, and soldering the tails to the pads. Then the circuit board with the connector housing parts thereon is placed on one of the housing halves such as the lower one 22, with ears 54, 56 of the connectors received in notches 60, 62 at the ends of the housing half. The upper housing half 24 is closed over the lower one and the housing halves are sealed together to complete the IC card.

The circuit board 32 has a ground plane 70 with exposed opposite side portions 72, 74 that lie at opposite side portions of the card on both its upper and lower surfaces. The circuit board must be accurately and securely mounted in the housing, with the circuit board surrounded in almost all directions by electrically conductive portions of the housing to guard against EMI (electromagnetic interference). Also, the ground plane 70 of the circuit board usually must be electrically connected to conductive portions at opposite sides of the housing to enable static discharge when the card is inserted into an electronic device.

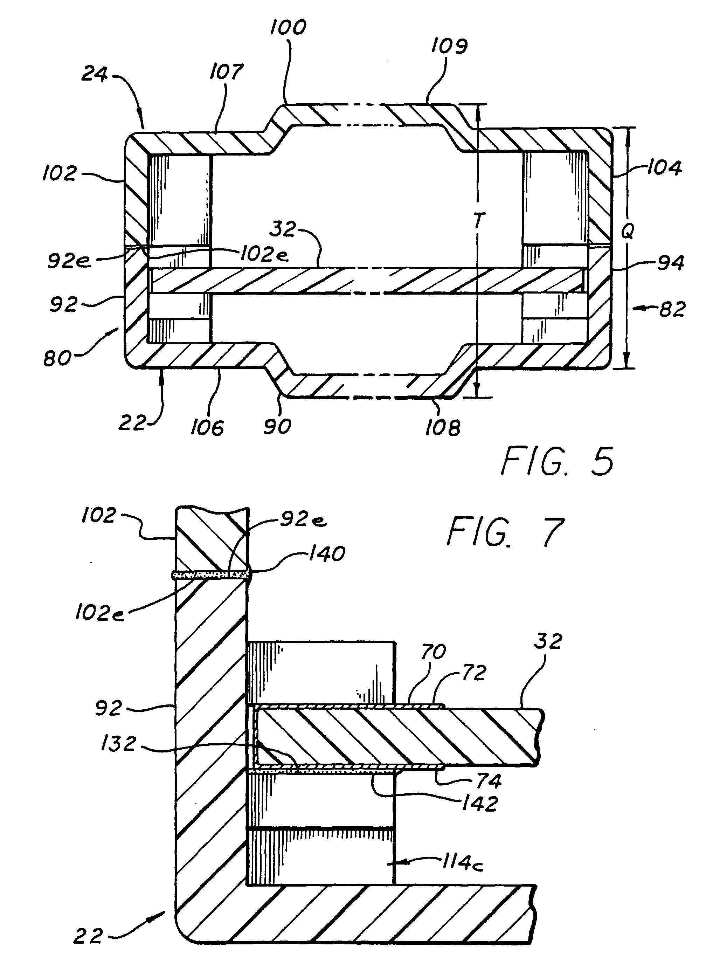

The housing has width-spaced opposite sides 80, 82 spaced by a maximum width dimension W (of 54mm), and has length-spaced front and rear ends 84, 86 spaced by a maximum length dimension L (of 85mm) in a longitudinal direction M. The housing also has a thickness-spaced top and bottom and a maximum thickness dimension T (of 4.8mm). The lower housing half 22 forms a lower cover portion 90 and a pair of upstanding flanges 92, 94 at opposite sides of the lower cover portion. Similarly, the upper housing half 24 has a top cover portion 100 and has opposite depending flanges 102, 104. When the lower and upper housing halves are joined, the flanges of the lower and upper housing halves abut one another and form a space between the cover portion in which the circuit board assembly 30 is received. Each cover portion 90, 100 has a peripheral portion 106, 107 (FIG. 5), and has a center portion 108, 109, with the secondary thickness Q between the peripheral portions being less than the maximum card thickness T.

The circuit board 32 (FIG. 2) has groups of longitudinally-spaced apertures 110, 112 at its opposite sides, which are labeled 110A, 110B, etc. and 112A, 112B etc. The lower housing half has a group of longitudinally-spaced lower platforms 114, 116 as its opposite sides, which are labeled 114A, 114C, 114E, and 116A, 116C, and 116E which receive corresponding apertures on the circuit board. The upper housing half has spaced upper platforms 120, 122 which are labeled 120B, 120D and 122B, 122D and which engage the circuit board. As described below, the platforms accurately locate the circuit board both horizontally and vertically, while preventing it from "rattling", and while providing good electrical contact with the ground plane of the circuit board.

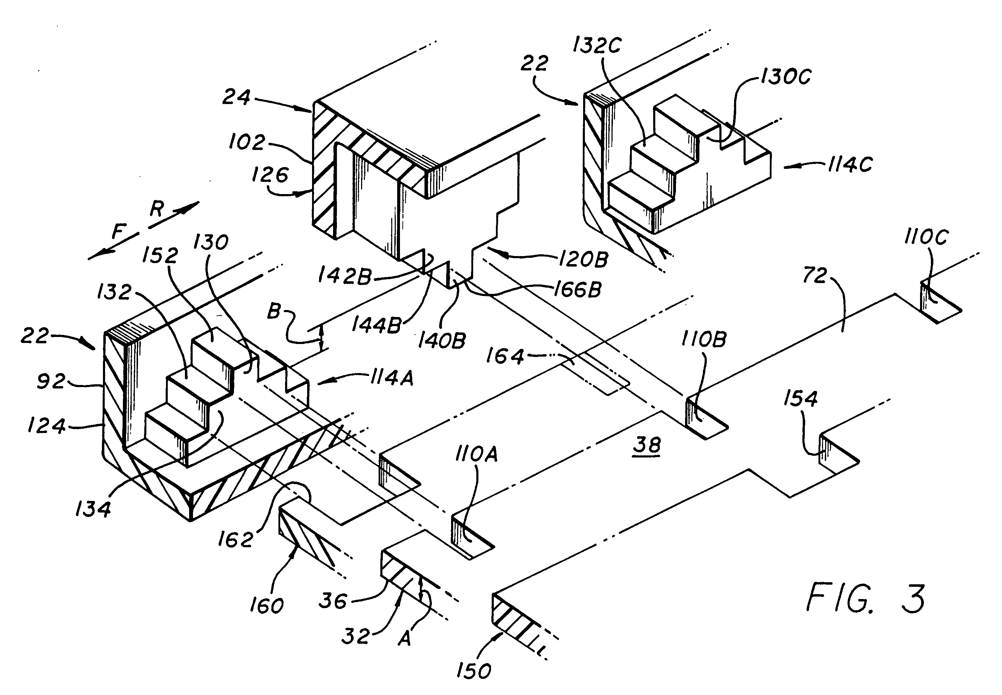

FIG. 3 shows portions of the lower and upper housing parts 22, 24 and a portion of the circuit board 32. Each of the flanges such as the lower flange 92 includes an outer wall 124, with the platforms lying inside the outer wall. The upper flange 102 is similarly constructed with an outer wall 126. The lower platform 114A has an uppermost or first step 130 which is received in a corresponding aperture 110A of the circuit board 32. The lower face 36 of the circuit board lies on an interrupted board-supporting surface 132 of a second step 134 of the platform. Thus, the aperture 110A of the circuit board is used to fix the horizontal position of the circuit board in forward and rearward directions F, R, while the lower surface 36 of the circuit board is vertically supported. Other lower platforms such as 114C have steps 130C and upwardly-facing surfaces 132C that support other locations along the circuit board side 72. All corresponding board-supporting surfaces such as 132, 132C lie in a common horizontal plane, with a step having a portion lying above that plane. The upper platforms such as 120B have lowermost or first steps such as 140B which are received in corresponding circuit board apertures such as 110B. The upper platform also has a second platform step 142B forming a downwardly-facing board-engaging surface 144B. The downwardly-facing surface 144B presses against the upper surface 38 of the circuit board 32.

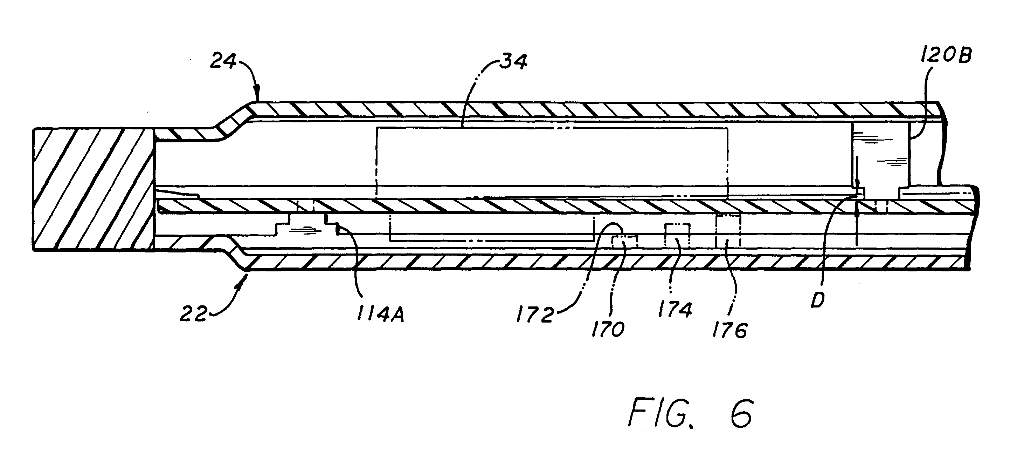

The circuit board 32 has a predetermined thickness A, and the difference B in heights of the board-engaging surfaces 132 and 144B in the assembled card, is slightly less than the circuit board thickness A. As a result, the portion of the circuit board around the slot 110B is downwardly deflected, as compared to the flat orientation which the board assumes in the absence of the upper platform part 120B. The resulting slight bend of the circuit board results in the circuit board pressing firmly against the platform surfaces 132, 144B, 132C, etc. In one IC card that applicant designed, with overall dimension described above, the circuit board had a thickness A of 1.26mm, and the board-engaging surfaces had a height difference B of 1.14mm, for a difference D (FIG. 6) of 0.12mm. The upper and lower platform parts such as 114A and 120B were longitudinally spaced apart by 16.5mm.

FIG. 5 is a sectional view of the assembled IC card, although only the circuit board 32 of the circuit board assembly is shown. It can be seen that the corresponding flanges 92, 102 of the lower and upper housing halves 22, 24 engage each other, by means of the ends 92e, 102e of the flanges substantially abutting one another. The other flanges 94, 104 are similarly connected together. The flanges of the lower and upper housing halves form substantially the entire height of the sides 80, 82 of the housing of the IC card.

Each of the housing halves 22, 24 is preferably molded of an electrically conductive polymer (e.g. silver particles in polyester), with the lower flanges 92, 94 being integrally molded with the lower cover portion 90, and with the upper flanges 102, 104 being molded integrally with the upper cover portion 100. A conductive molded plastic material has a bulk resistivity that is about two orders of magnitude greater than that of copper (whose electrical resistivity is 1.7 microhm-centimeter). However, the resistivity of such conductive plastic material is moderate, and is considered to be electrically conductive when its resistivity is less than four orders of magnitude greater than that of copper. It is possible to embed a thin metal sheet or foil in each housing half when molding it, although each housing half is still formed primarily of a conductive polymer.

An important advantage of the construction shown in FIG. 5, is that, except for the housing connector parts, this results in the housing being formed primarily of two parts, with the conductive sides providing EMI (electromagnetic interference) protection at the sides of the card. The circuit board is securely held in place against "rattling" by the platforms of the lower and upper housing halves, and these platforms also provide contact of each of the housing halves with the circuit board ground plane.

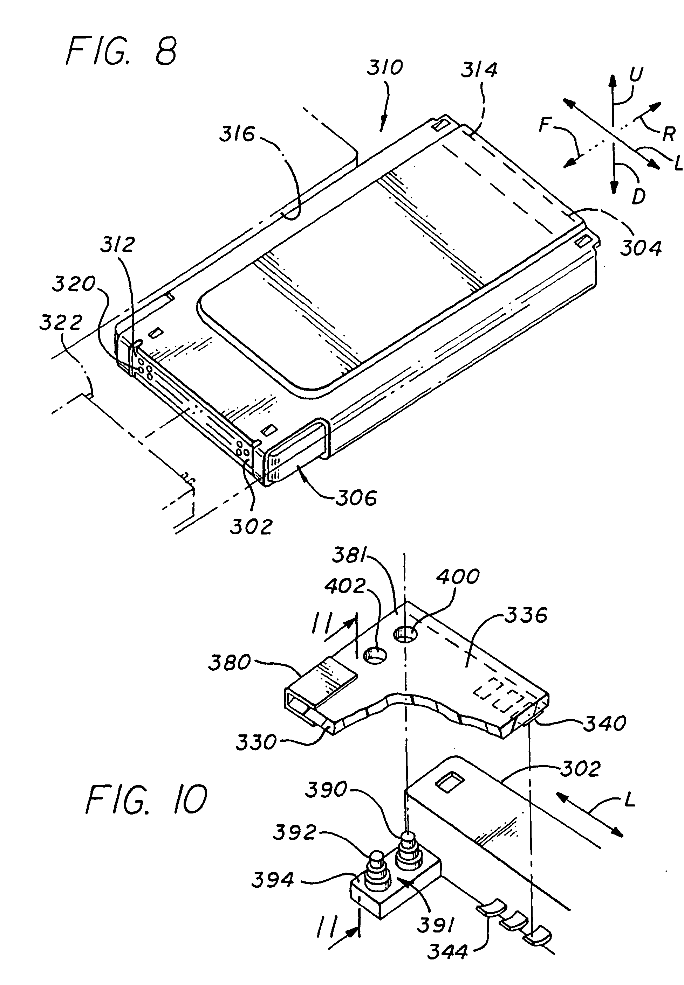

FIG. 7 is an enlarged view of a portion of FIG. 5, showing one side 72 of the ground plane 70 of the circuit board 32, and showing the substantially abutting edges 92e, 102e of the flanges 92, 102. FIG. 7 shows a quantity of electrically conducted adhesive 140 which joins the flange ends to seal them against the entrance of dirt while providing good electrical contact between them. A quantity of conductive paste 142 which has been placed on the board-engaging surface 132 of a platform part 114C, assures better electrical contact between the ground plane 70 and the housing lower half 22.

FIG. 3 not only shows circuit board 32, but shows another, alternative circuit board 150 which is designed to rest on a top board-engaging surface or surface region 152 of the lower platform part 114A. The circuit board 150 has a slot 154 which receives the second step 142B of the upper platform part 120B so the upper platform part can press down on the circuit board at a region immediately surrounding the slot 154. FIG. 4 shows the circuit board 150 lying on the surface 152 of the lower platform part 114A. The advantage of this arrangement is that it provides more room below the lower surface 156 of the circuit board, although it results in less room above the upper surface 158. This arrangement allows somewhat taller components to be mounted on the lower surface 156 of the board, although it may require somewhat shorter components on the upper surface.

FIG. 3 shows another alternate circuit board 160 which has a wide slot 162 which receives the second step 134 of the lower platform part 114A. The circuit board 160 has a region at 164 which is pressed down by a lower surface 166B of the upper platform part 120B. The circuit board 160 results in the greatest height above the circuit board. It is noted that circuit board components are available in a range of sizes, with those of larger heights often being less expensive than those of smaller heights, especially in the case of integrated circuits. The ability to vary the available height above and below the circuit board, enables the use of circuit components of a total minimal cost.

As shown in FIG. 6, it would be possible to provide platforms such as 170 with board-supporting surfaces 172, and to provide steps such as 174 and 176 at locations spaced from the platform 170. Applicant prefers to form the steps so they project from the board-supporting surfaces of the platforms.

FIG. 8 illustrates another IC card 310 which has connectors 312, 314 at its front and rear ends, respectively. The connectors have connector housing frames or parts 302, 304 that form parts of the connector housing 306. The card can be inserted in a forward direction F into an electronic devices 316, until contacts 320 held by the front connector housing part 302 engage corresponding contacts 322 of the electronic device. The card is withdrawn in a rearward direction R. The card has JEIDA dimensions, in upward and downward directions U, D, lateral directions L and longitudinal directions F, R.

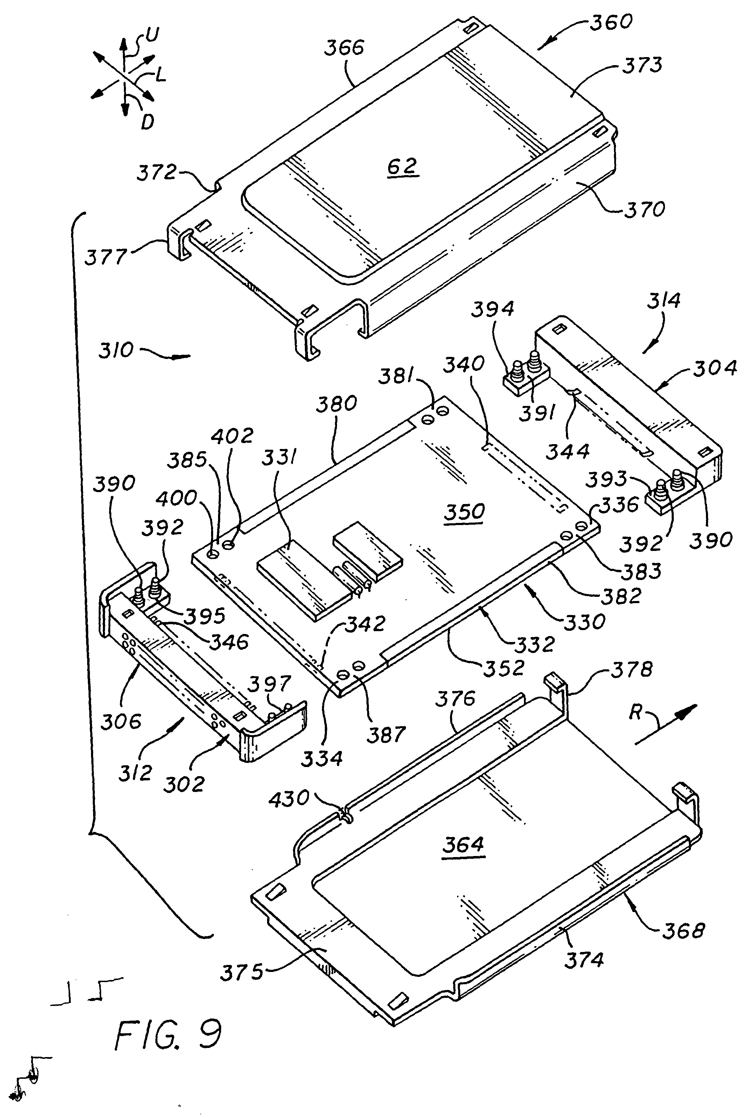

FIG. 9 shows that the IC card includes a circuit board assembly 330 with electronic components 331 mounted on a circuit board 332. The circuit board has laterally opposite side 380, 382 and forward and rearward end portions 334, 336, and has laterally-extending rows of contact pads 340, 342 at its opposite end portions. The front and rear housing connector parts, or connector housing parts 302, 304 each comprises a block of molded plastic, which holds at least one laterally extending row of contacts with contact tails 344, 346 constructed to engage corresponding rows of contact pads 340, 342 on the circuit board. It is noted that the circuit board has upper and lower surfaces 350, 352, and the contact pads are normally located on the lower surface 352.

The housing 306 includes a cover 360 with upper and lower cover parts 366, 368 that have sheet-like portions 362, 364 that lie respectively above and below a majority of the surface area of the circuit board. A pair of upper side flanges 370, 372 of the upper cover part engage corresponding lower side flanges 374, 376 of the lower cover part. The parts are assembled by first mounting the circuit board opposite end portions on the connector housing parts 302, 304. This subassembly is placed in the lower cover part 368. The rear 373 of the upper cover part is placed at the front 375 of the lower one, and the upper cover part is slid in the rearward direction R. U-shaped fingers 377, 378 at the front and rear of corresponding cover parts help to keep the fully assembled cover parts in place on the connectors.

Previous JEIDA IC cards have used a molded plastic frame which held the other parts together. U.S. Patents 5,207,586 and 5,244,397 show IC cards of this type. In previous and present IC cards there is some mechanical connection between the circuit board and the housing connector parts through the solder connections of contact tails 344, 346 with the conductive pads 340, 342 on the circuit board. However, such solder connections cannot be relied upon for strong mechanical coupling, which was previously achieved by the molded plastic frame.

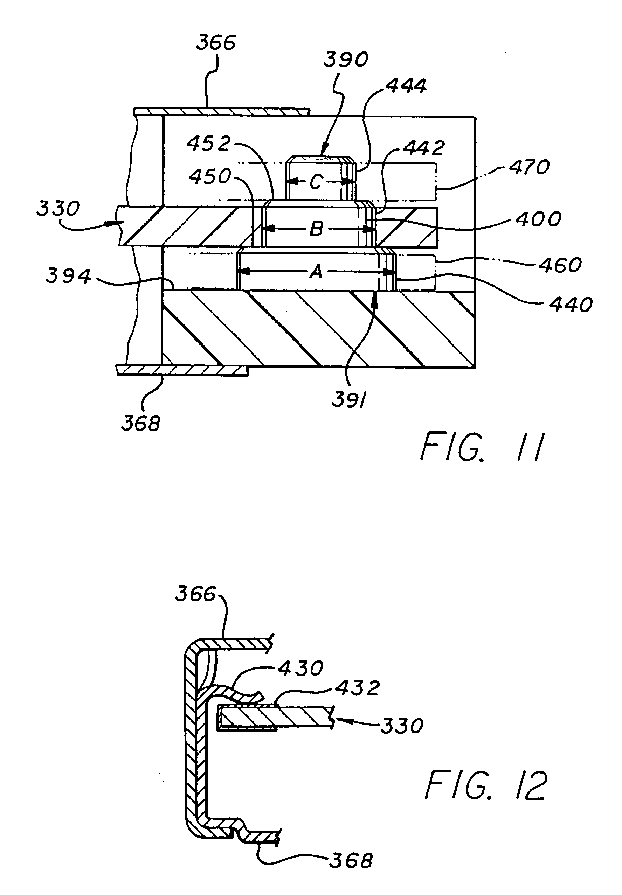

The IC card 310 is frameless, with the opposite end portions 334, 336 of the circuit board mounted directly on the front and rear connector housing parts 302, 304. The rear end portion 336 of the board has board mount parts 381, 383 at its opposite sides, that mount on the rear connector housing part 304, and the front end portion 334 of the board has board mount parts 385, 387 that mount on the front connector housing part 302. The connector housing parts have corresponding support parts 391, 393, 395 and 397, with all mount parts being similar and all support parts being similar. As shown in FIG. 10, each circuit board mount part such as 381, extends laterally beyond a corresponding row of contact pads 340 (e.g. laterally beyond an end of the row). Each board mount part such as 381 of the circuit board end portion is directly mounted on a corresponding connector support part such as 391 which extends laterally beyond a corresponding row of contacts 344.

Each support part such as 391, forms a platform with first and second sets of steps 390, 392 in the form of pegs that project up from a first board-supporting surface 394. The side 380 of the circuit board which forms the mount part 381, has a pair of apertures 400, 402 that are designed to closely receive the corresponding set of steps 390, 392. Thus, the front and rear connectors form an apparatus for holding the circuit board. It is noted that the covers are directly mounted on the front and rear connector housing parts, as is the circuit board 330. No intermediate frame apart from the cover parts 366, 368 and the circuit board, extends between the connector housing parts 302, 304. It is noted that there is a grounding electrical connection between the cover and a ground plane of the circuit board. Fig. 12 shows that the lower cover part 368 has a tab 430 which engages a location on a ground plane 432. However, this does not provide a rigid connection or mechanical support, and there is substantially no other direct connection between the circuit board and cover.

Figs. 10 and 11 show that each platform such as 391 has a group of steps 390, 392, with each group such as 390 having steps 440, 442, and 444. The first step 440 is of greatest width A, while the second and third steps 442, 444 have progressively smaller widths B and C. The platform 391 forms board-supporting surfaces or surface regions 394, 450, 452 at the bottom of each step. The holes such as 400 in the circuit board 330, are shown in Fig. 11 as having a hole width B so the walls of the circuit board holes are closely received in the second steps 342, and the lower surface of the circuit board rests on the second board-supporting surface 450.

A manufacturer of the card housing parts commonly sells such parts to a firm that designs and constructs a circuit board with its own circuitry thereon, and assembles the card. The circuit board manufacturer usually has drills that can form the holes such as 400, 402 in a precise pattern. The circuit board manufacturer can choose the particular height of the circuit board on the connector housing by choosing the diameter of the circuit board holes that he drills. A particular height of the circuit board above the first surface 394, is chosen so that the desired circuit components can be mounted on the circuit board. If an engineer who designs the circuit board requires components of large vertical thickness, he may drill small holes to receive platform steps 444, so the circuit board 470 rests on the third platform 452. If the engineer wishes to cram a large number of circuit components of moderately small thickness onto the board, he can use large diameter holes to receive platform steps 440, so a circuit board 460 rests on the first surface region 390.

A variety of approaches can be used to securely fasten the circuit board in place after its holes have received the pegs, including press fitting onto the steps or adhesive. It should be noted that in some cards, no contacts are required at the rear of the card, in which case the rear connector housing part can be formed by a block of molded plastic without contacts.

Although terms such as "vertical", "horizontal", "upper and lower", etc, have been used herein to describe the parts of the IC card as shown in the figures, it should be understood that the IC card and its parts can be assembled and used in any orientation with respect to gravity.

Thus, the invention provides an IC card which is of simplified construction and which simplifies selection of circuit board height with respect to the connectors. The housing of the card has a plurality of platforms, each with a step, and the circuit board has a plurality of apertures that receive the steps. Each platform can have a plurality of steps of different heights, with a board-supporting surface at the bottom and/or top of at least one step, to support a circuit board at a selected one of a plurality of heights. One IC card has lower and upper housing halves, with platforms at their sides that support the circuit board. The platforms can be positioned to slightly deflect the circuit board edges. Another IC card is frameless, in that opposite end portions of the circuit board are directly and rigidly connected to front and rear connector housing parts. The connection of each circuit board end portion to a connector housing part is preferably accomplished at locations laterally beyond the row or rows of contacts of the connector, so that attachment occurs in connector regions of moderately small vertical thickness. Such connections can be accomplished by providing platforms on the connectors which, have steps that are received in apertures formed in the circuit board. In this case, the platforms are preferably of circular shape so that they can be received in round apertures that can be simply drilled by circuit board makers. Each step of a platform can have a board-supporting surface at the step bottom, and with a higher step having a smaller width than a lower one. This enables a circuit board maker to choose which step will be received, by choosing the width or diameter of the aperture that he will form in the circuit board.

Although particular embodiments of the invention have been described and illustrated herein, it is recognized that modifications and variations may readily occur to those skilled in the art.

## Claims

1. An IC card which includes a housing (20, 306) consisting of upper and lower integrally formed housing portions (24, 22, 366, 368) with laterally-spaced first and second opposite sides (80, 82, 380, 382) and longitudinally spaced first and second opposite ends (84, 86, 373, 375), and a circuit board assembly (30, 330) lying in said housing, said circuit board assembly including a circuit board (32, 332) having upper and lower faces (38, 36, 350, 352) and a plurality of components (34, 331) mounted on said board and projecting from at least one face thereof, characterized by:
said lower housing portion (22) includes a plurality of primarily upwardly-facing board-supporting surfaces (132, 152, 394, 450, 452) with a plurality of said board-supporting surfaces lying substantially in each of at least two vertically-spaced horizontal planes, to enable support of a circuit board lower face in a selected one of said horizontal planes.

2. The IC card described in claim 1 wherein:
said housing lower portion (22) has a plurality of lower platforms (114, 116, 390, 392) at each of said first and second housing sides, each platform having at least two steps (130, 134, 440, 442, 444) with one of said board-supporting surfaces (132, 394, 450, 452) lying at the bottom of each step;
said circuit board has opposite sides each has apertures (110, 112, 400, 402) therein, with each of said circuit board sides being supported by a plurality of said board-supporting surfaces and with each of said plurality of apertures receiving one of said steps.

3. The IC card described in claim 1 or 2 wherein:
said housing upper portion (24) has at least one upper platform (120, 122) at each of said housing sides, with each upper platform having a primarily downwardly-facing board-engaging surface (166B, 144B) lying between two of said lower platforms and engaging said circuit board.

4. The IC card described in at least one of claims 1 to 3 wherein:
each of said board-engaging surfaces on one of said upper platforms (120, 122) lies at a height that is a distance (D) slightly below a corresponding one of said board-supporting surfaces on said lower platforms; said circuit board has a first side which extends between and lies on said board-supporting surfaces of said lower platforms and that is downwardly-deflected by said board-engaging surface of one of said upper platforms.

5. An IC card which includes a housing (306) and a circuit board assembly (330) lying in said housing and having a circuit board (332) with circuit components (331) thereon, said circuit board having forward and rearward end portions (334, 336), opposite sides (380, 382), and upper and lower surfaces (350, 352), with said circuit board forward end portion having a row of contact pads (342), said housing including longitudinally spaced front and rear ends (375, 373) and front and rear housing connector parts (312, 314) thereat, with at least said front connector part (312) having a middle portion holding a row of contacts (346) engaged with said contact pads (342) and having a pair of opposite connector side portions, characterized by:
said circuit board ends are mounted respectively on said front and rear connector parts, with said front connector part (312) having a pair of support parts (395, 397) each extending rearwardly from one of said opposite connector side portions, with each of said front support parts having a board-supporting surface (394) and at least one peg (390, 392) projecting above the board-supporting surface, *with said at least one peg having at least two steps (440, 442, 444) and with primarily upwardly-facing board-supporting surfaces* (*450, 452) at the bottom of each step*, *with each board-supporting surface lying substantially in one of at least two vertically-spaced horizontal planes,* with said circuit board front end portion having opposite sides that each has at least one hole that receives a corresponding one of said pegs.

6. The IC card described in claim 5 wherein:
said circuit board holes are round drilled holes that are each spaced from the periphery of the circuit board.

7. The IC card described in claim 5 or 6 wherein:
*said at least two steps (440,442,444) of said at least one peg* including a lower step (440) with a bottom forming a first board-supporting surface (394) and including an upper step (442, 444) that is narrower than said lower step and that projects upwardly from a top of said lower step and with the bottom of said upper step forming a second board-supporting surface (450, 452).

8. A method for producing an IC card which has a circuit board assembly (30, 330) that includes a circuit board (32) with opposite board sides, and a housing (20, 306) consisting of upper and lower integrally formed housing portions (24, 22, 366, 368), opposite housing sides, and opposite housing ends (84, 86, 373, 375), wherein said housing has been formed with a plurality of platforms (114, 116, 120, 122, 390, 392) with board-supporting surfaces (132, 152, 394, 450, 452) at each of said sides of said lower housing portion, with at least two board-supporting surfaces at each housing side lying in a first horizontal plane and at least two board-supporting surfaces at each housing side lie in a second horizontal plane,
characterized by:
forming each of said opposite sides of said circuit board to lie on selected ones of said board-supporting surfaces that lie on a selected one of said planes, and mounting said circuit board including lowering said circuit board onto said selected board-supporting surfaces.

9. The method described in claim 8 wherein said lower housing portion has been formed with a plurality of platforms with each platform having a plurality of steps (114, 116, 120, 122, 440, 442, 444) and with a board-supporting surface (132, 344, 450, 452) at the bottom of each step, wherein:
said step of forming said circuit board includes forming a plurality of apertures (110, 112, 400, 402) in each side of said circuit board with each aperture being wide enough to closely receive one of said steps.

10. A method for *constructing and assembling* an IC card which has a circuit board assembly (330) that includes a circuit board (350) with front and rear ends and opposite board sides, and a housing (20, 306) with upper and lower housing portions (366, 368), opposite housing sides, and front and rear connector parts (312, 314) forming opposite housing ends, with at least said front connector part having a laterally-extending row of contacts (346), wherein said front connector part has been formed with a pair of support parts (395, 397) at locations laterally beyond said row of contacts, and an upstanding peg (390, 392) has been established at each of said support parts, characterized by:
drilling a round hole (400, 402) at each of said opposite sides of said front end of said circuit board, at locations spaced from the edge of the circuit board,
providing *said upstanding peg with at least two steps (440, 442, 444) and with primarily upwardly-facing board-supporting surfaces* (*450*, *452) at the bottom of each step, with each board-supporting surface lying substantially in one of at least two vertically-spaced horizontal planes, to en*
*able support of the circuit* board *front end in a selected one of said horizontal planes;*
and mounting said circuit board including lowering said circuit board front end onto said board-supporting surfaces and receiving said pegs in said circuit board holes.

## Patentansprüche

1. Eine IC-Karte, die ein Gehäuse (20, 306) aus oberen und unteren integral ausgebildeten Gehäusebereichen (24, 22, 366, 368) mit seitlich versetzten ersten und zweiten gegenüberliegenden Seiten (80, 82, 380, 382) und längsversetzten ersten und zweiten gegenüberliegenden Enden (84, 86, 373, 375) und eine Leiterplattenbaugruppe (30, 330) enthält, die in dem Gehäuse liegt, wobei die Leiterplattenbaugruppe eine Leiterplatte (32, 332) mit oberen und unteren Flächen (38, 36, 350, 352) und mehrere Komponenten (34, 331) enthält, die auf der Leiterplatte befestigt sind und von mindestens einer ihrer Flächen hervorragt, dadurch gekennzeichnet,
daß der untere Gehäusebereich (22) mehrere hauptsächlich nach oben weisende Leiterplattenauflageflächen (132, 152, 394, 450, 452) umfaßt, wobei mehrere Leiterplattenauflageflächen im wesentlichen auf jeder von zumindest zwei vertikal versetzten horizontalen Ebenen liegen, um so die Auflage einer unteren Fläche der Leiterplatte in einer ausgewählten horizontalen Ebene zu ermöglichen.

2. Die IC-Karte nach Anspruch 1, wobei
der untere Gehäusebereich (22) mehrere untere Plattformen (114, 116, 390, 392) an jeder der ersten und zweiten Gehäuseseite aufweist, wobei jede Plattform mindestens zwei Abstufungen (130, 134, 440, 442, 444) hat, wobei eine der Leiterplattenauflageflächen (132, 394, 450, 452) am Boden jeder Abstufung liegt;
die gegenüberliegenden Seiten der Leiterplatte Öffnungen (110, 112, 400, 402) aufweisen, wobei jede Seite der Leiterplatte von mehreren Leiterplattenauflageflächen unterstützt wird und jeder der mehreren Öffnungen eine der Abstufungen aufnimmt.

3. Die IC-Karte nach Anspruch 1 oder 2, wobei
der obere Gehäusebereich (24) mindestens eine obere Plattform (120, 122) an jeder seiner Gehäuseseiten hat, wobei jede obere Plattform eine hauptsächlich nach unten weisende Fläche (166B, 144B) zum Halten der Leiterplatte hat, die zwischen zwei der unteren Plattformen liegen und die Leiterplatte hält.

4. Die IC-Karte nach mindestens einem der Ansprüche 1 bis 3, wobei
jede der Flächen zum Halten der Leiterplatte auf einer der oberen Plattformen (120, 122) auf einer Höhe liegt, die um eine Strecke (D) leicht unterhalb einer entsprechenden Leiterplattenauflagefläche auf den unteren Plattformen liegt;
die Leiterplatte eine erste Seite hat, die sich zwischen den Leiterplattenauflageflächen der unteren Plattformen erstreckt und darauf liegt sowie durch die Fläche zum Halten der Leiterplatte einer der unteren Plattformen nach unten abgelenkt ist.

5. Eine IC-Karte, die ein Gehäuse (306) und eine Leiterplattenbaugruppe (330) enthält, die sich im Gehäuse befindet und eine Leiterplatte (332) mit Schaltungskomponenten (331) aufweist, wobei die Leiterplatte vordere und hintere Endbereiche (334, 336), gegenüberliegende Seiten (380, 382) und obere und untere Flächen (350, 352) hat, wobei der vordere Endbereich der Leiterplatte eine Reihe mit Kontaktfeldern (342) hat, wobei das Gehäuse längsweise versetzte vordere und hintere Enden (375, 373) und vordere und hintere Gehäuseverbinderteile (312, 314) darauf hat, wobei zumindest das vordere Gehäuseverbinderteil (312) einen mittleren Teilbereich hat, der eine Reihe mit Kontakten (346), die mit den Kontaktfeldern (342) verbunden sind, und zwei gegenüberliegende Seitenbereiche des Verbinders aufweist, dadurch gekennzeichnet,
daß die Leiterplattenenden jeweils auf den vorderen und hinteren Verbinderteilen montiert sind, wobei das vordere Verbinderteil (312) zwei Auflageteile (395, 397) hat, die sich von einem der gegenüberliegenden Verbinderseitenbereiche nach hinten erstrecken, wobei jedes vordere Auflageteil eine Leiterplattenauflagefläche (394) und mindestens einen Zapfen (390, 392) hat, der über der Leiterplattenauflagefäche hervorsteht, wobei mindestens ein Zapfen mindestens zwei Abstufungen (440, 442, 444) mit hauptsächlich nach oben weisenden Leiterplattenauflageflächen (450, 452) am Boden jeder Abstufung hat, wobei jede Leiterplattenauflagefläche im wesentlichen in einer der mindestens zwei vertikal versetzten horizontalen Ebenen liegt und wobei der vordere Endbereich der Leiterplatte gegenüberliegende Seiten hat, die jeweils mindestens ein Loch haben, das einen entsprechenden Zapfen aufnimmt.

6. Die IC-Karte nach Anspruch 5, wobei
die Leiterplattenlöcher runde Bohrlöcher sind, die jeweils von der Peripherie der Leiterplatte abgesetzt sind.

7. Die IC-Karte nach Anspruch 5 oder 6, wobei
die mindestens zwei Abstufungen (440, 442, 444) des mindestens einen Zapfens eine untere Abstufung (440) mit einem Boden, der eine erste Leiterplattenauflagefläche (394) bildet, und eine obere Abstufung (442, 444) aufweist, die schmaler als die untere Abstufung ist und von der Oberseite der unteren Abstufung nach oben hervorsteht, wobei der Boden der oberen Abstufung eine zweite Leiterplattenauflagefläche (450, 452) bildet.

8. Eine Methode zur Herstellung einer IC-Karte, die eine Leiterplattenbaugruppe (30, 330) aufweist, die eine Leiterplatte (32) mit gegenüberliegenden Seiten und ein Gehäuse (20, 306) hat, das aus oberen und unteren integral ausgebildeten Gehäusebereichen (24, 22, 366, 368), gegenüberliegenden Gehäuseseiten und gegenüberliegenden Gehäuseenden (84, 86, 373, 375) besteht, wobei das Gehäuse mit mehreren Plattformen (114, 116, 120, 122, 390, 392) mit Leiterplattenauflageflächen (132, 152, 394, 450, 452) an jeder Seite des unteren Gehäusebereichs ausgebildet ist, wobei mindestens zwei Leiterplattenauflageflächen an jeder Gehäuseseite in einer ersten horizontalen Ebene und mindestens zwei Leiterplattenauflageflächen an jeder Gehäuseseite in einer zweiten horizontalen Ebene liegen, gekennzeichnet durch,
das Formen der gegenüberliegenden Seiten der Leiterplatte, so daß sie auf ausgewählten Leiterplattenauflageflächen, die auf einer ausgewählten Ebene liegen, zu liegen kommt, und das Befestigen der Leiterplatte einschließlich des Absenkens der Leiterplatte auf die ausgewählten Leiterplattenauflageflächen.

9. Die Methode nach Anspruch 8, wobei der untere Gehäusebereich mit mehreren Plattformen, von denen jede mehrere Abstufungen (114, 116, 120, 122, 440, 442, 444) hat, und mit einer Leiterplattenauflagefläche (132, 344, 450, 452) am Boden jeder Abstufung ausgebildet ist, wobei:
der Schritt des Formens der Leiterplatte das Formen mehrere Öffnungen (110, 112, 400, 402) in jeder Seite der Leiterplatte einschließt, wobei jede Öffnung breit genug ist, um eine der Abstufungen schlüssig aufzunehmen.

10. Eine Methode zum Bau und zur Montage einer IC-Karte, die eine Leiterplattenbaugruppe (330) , die eine Leiterplatte (350) mit vorderen und hinteren Enden und gegenüberliegenden Leiterplattenseiten einschließt, und ein Gehäuse (20, 306) mit oberen und unteren Gehäusebereichen (366, 368), gegenüberliegenden Gehäuseseiten und vorderen und hinteren Verbinderteilen (312, 314) aufweist, die gegenüberliegende Gehäuseenden bilden, wobei mindestens das vordere Verbinderteil eine sich seitlich erstreckende Reihe mit Kontakten (346) hat, wobei das vordere Verbinderteil aus zwei Auflageteilen (395, 397) an Stellen, die seitlich hinter der Kontaktreihe liegen, geformt ist, und wobei ein aufrecht stehender Zapfen (390, 392) auf jedem Auflageteil vorgesehen ist, gekennzeichnet durch
das Bohren eines runden Loches (400, 402) an jeder gegenüberliegenden Seite des vorderen Endes der Leiterplatte an Stellen, die vom Rand der Leiterplatte abgesetzt sind; das Vorsehen des aufrecht stehenden Zapfens mit mindestens zwei Abstufungen (440, 442, 444) und mit hauptsächlich nach oben weisenden Leiterplattenauflageflächen (450, 452) am Boden jeder Abstufung, wobei jede Leiterplattenauflagefläche im wesentlichen in einer von mindestens zwei vertikal versetzten horizontalen Ebenen liegt, um eine Auflage des vorderen Leiterplattenendes in einer ausgewählten horizontalen Ebene zu ermöglichen;
und das Befestigen der Leiterplatte einschließlich des Absenkens des vorderen Leiterplattenendes auf die Leiterplattenauflageflächen und des Aufnehmens der Zapfen in den Leiterplattenlöchern.

## Revendications

1. Carte à circuits intégrés qui inclut un boîtier (20, 306) constitué d'une partie de boîtier supérieure et d'une partie de boîtier inférieure (24, 22, 366, 368) formées de manière intégrée, avec des premiers et des deuxièmes côtés opposés (80, 82, 380, 382) espacés en sens latéral et des premières et des deuxièmes extrémités opposées (84, 86, 373, 375) espacées en sens longitudinal, et un ensemble de carte à circuit (30, 330) reposant dans ledit boîtier, ledit ensemble de carte à circuit incluant une carte à circuit (32, 332) ayant une face supérieure et une face inférieure (38, 36, 350, 352) et une pluralité de composants (34, 331) montés sur ladite carte et en projection depuis au moins une face de celle-ci, caractérisée par le fait que :
ladite partie de boîtier inférieure (22) inclut une pluralité de surfaces de support de cartes (132, 152, 394, 450, 452) principalement tournées vers le haut, de sorte qu'une pluralité desdites surfaces de support de cartes sont disposées sensiblement dans chacun d'au moins deux plans horizontaux espacés en sens vertical, pour permettre de supporter une face inférieure d'une carte à circuits dans un plan choisi parmi lesdits plans horizontaux.

2. Carte à circuits intégrés selon la revendication 1, dans laquelle:
ladite partie de boîtier inférieure (22) possède une pluralité de plates-formes inférieures (114, 116, 390, 392) au niveau de chacun desdits premiers et deuxièmes côtés du boîtier, chaque plate-forme ayant au moins deux gradins (130, 134, 440, 442, 444), de sorte que l'une desdites surfaces de support de carte (132, 394, 450, 452) est située au fond de chaque gradin ; et
chaque carte à circuit présente des côtés opposés dont chacun comporte des ouvertures (110, 112, 400, 402), et chacun desdits côtés des cartes à circuit étant supportée par une pluralité desdites surfaces de support de carte, et chacune desdites ouvertures de ladite pluralité d'ouvertures recevant l'un desdits gradins.

3. Carte à circuits intégrés selon l'une ou l'autre des revendications 1 et 2, dans laquelle ladite partie supérieure de boîtier (24) possède au moins une plate-forme supérieure (120, 122) au niveau de chacun desdits côtés de boîtier, chacune desdites plates-formes supérieures ayant une surface d'engagement de carte (166B, 144B) principalement tournée vers le bas, située entre deux desdites plates-formes inférieures et engageant ladite carte à circuits.

4. Carte à circuits intégrés selon l'une au moins des revendications 1 à 3, dans laquelle :
chacune desdites surfaces d'engagement de carte de l'une desdites plates-formes supérieures (120, 122) est située à une hauteur qui se trouve à une distance (D) légèrement au-dessous d'une surface correspondante parmi lesdites surfaces de support de carte sur lesdites plates-formes inférieures ; et
ladite carte à circuit présente un premier côté qui s'étend entre lesdites surfaces de support de cartes et repose sur lesdites surfaces de support de carte desdites plates-formes inférieures, et qui est fléchie vers le bas par ladite surface d'engagement de carte de l'une desdites plates-formes supérieures.

5. Carte à circuits intégrés qui inclut un boîtier (306) et un ensemble de carte à circuit (330) reposant dans ledit boîtier et ayant une carte à circuit (332) avec des composants de circuits (331) sur elle-même, ladite carte à circuit ayant une partie d'extrémité antérieure et une partie d'extrémité postérieure (334, 336), des côtés opposés (380, 382), et une surface supérieure et une surface inférieure (350, 352), ladite partie terminale antérieure de la carte à circuit ayant une rangée de patins de contact (342), ledit boîtier incluant une extrémité frontale et une extrémité postérieure (375, 373) espacées en sens longitudinal, et une partie de connecteur de boîtier frontale et une partie de connecteur de boîtier postérieure (312, 314) au niveau de ces extrémités, ladite partie de connecteur frontale au moins (312) ayant une partie médiane qui maintient une rangée de contacts (346) en engagement avec lesdits patins de contact (342) et ayant une paire de parties latérales de connecteur opposées, caractérisée par le fait que lesdites extrémités de la carte à circuit sont montées respectivement sur ladite partie de connecteur frontale et sur ladite partie de connecteur postérieure, ladite partie de connecteur frontale (312) comprenant une paire de parties de support (395, 397) qui s'étendent chacune vers l'arrière depuis l'une desdites parties latérales de connecteur opposées, et chacune desdites parties de support frontales ayant une surface de support de carte (394) et au moins un doigt (390, 392) qui se projette au-dessus de la surface de support de carte, ledit au moins un doigt ayant au moins deux gradins (440, 442, 444), et présentant au fond de chaque gradin des surfaces de support de carte (450, 452) principalement tournées vers le haut, chaque surfacé de support de carte reposant sensiblement dans un plan parmi au moins deux plans horizontaux espacés en sens vertical, et ladite partie d'extrémité antérieure de la carte à circuit ayant des côtés opposés qui présentent chacun au moins un trou qui reçoit un doigt correspondant parmi lesdits doigts.

6. Carte à circuits intégrés selon la revendication 5, dans laquelle lesdits trous de la carte à circuits sont des trous cylindriques percés, espacés chacun depuis la périphérie de la carte à circuit.

7. Carte à circuits intégrés selon l'une ou l'autre des revendications 5 et 6, dans laquelle lesdits au moins deux gradins (440, 442, 444) dudit au moins un doigt incluent un gradin inférieur (440) avec un fond qui forme une première surface de support de carte (394), et incluent un gradin supérieur (442, 444) qui est plus étroit que ledit gradin inférieur et qui se projette vers le haut depuis le sommet dudit gradin inférieur, et le fond dudit gradin supérieur formant une deuxième surface de support de carte (450, 452).

8. Procédé pour produire une carte à circuits intégrés qui possède un ensemble de carte à circuits (30, 330) qui inclut une carte à circuits (32) avec des côtés de carte opposés, et un boîtier (20, 306) constitué d'une partie de boîtier supérieure et d'une partie de boîtier inférieure (24, 22, 366, 368) formées de manière intégrée, des côtés de boîtier opposés, et des extrémités de boîtier opposées (84, 86, 373, 375), dans lequel ledit boîtier a été formé avec une pluralité de plates-formes (114, 116, 120, 122, 390, 392) avec des surfaces de support de carte (132, 152, 394, 450, 452) au niveau de chacun desdits côtés de ladite partie de boîtier inférieure, et deux surfaces de support de carte au moins au niveau de chaque côté du boîtier étant situées dans un premier plan horizontal, et deux surfaces de support de carte au moins au niveau de chaque côté du boîtier étant situées dans un deuxième plan horizontal,
caractérisé par l'opération consistant à former chacun desdits côtés opposés de ladite carte à circuits de manière à reposer sur des surfaces choisies parmi lesdites surfaces de support de carte qui reposent sur un plan choisi parmi lesdits plans, et en ce que le montage de ladite carte à circuits inclut d'abaisser ladite carte à circuits sur lesdites surfaces de support de carte choisies.

9. Procédé selon la revendication 8, dans lequel ladite partie de boîtier inférieure a été formée avec une pluralité de plates-formes, chacune desdites plates-formes ayant une pluralité de gradins (114, 116, 120, 122, 440, 442, 444) et avec une surface de support de carte (132, 344, 450, 452) au fond de chaque gradin, dans lequel ladite opération consistant à former ladite carte à circuits inclut de former une pluralité d'ouvertures (110, 112, 400, 402) dans chaque côté de ladite carte à circuits, chacune desdites ouvertures étant suffisamment large pour recevoir de manière intime l'un desdits gradins.

10. Procédé pour construire et assembler une carte à circuits intégrés qui possède un ensemble de carte à circuits (330) qui inclut une carte à circuits (350) avec des extrémités frontale et postérieure, et des côtés de carte opposés, et un boîtier (20, 306) avec des parties de boîtier supérieure et inférieure (366, 368), des côtés de boîtier opposés, et des parties de connecteur frontale et postérieure (312, 314) formant des extrémités de boîtier opposées, ladite partie de connecteur frontale au moins ayant une rangée de contacts (346) qui s'étend latéralement, ladite partie de connecteur frontale a été formée avec une paire de parties de support (395, 397) à des emplacements latéralement au-delà de ladite rangée de contacts, et un doigt dressé (390, 392) a été établi au niveau de chacune desdites parties de support, caractérisé par les opérations consistant à :
percer un trou cylindrique (400, 402) au niveau de chacun desdits côtés opposés de ladite extrémité frontale de ladite carte à circuits, à des emplacements espacés de la bordure de la carte à circuits,
pourvoir ledit doigt dressé d'au moins deux gradins (440, 442, 444) et de surfaces de support de carte (450, 452) principalement tournées vers le haut au fond de chaque gradin, chacune desdites surfaces de support de carte reposant sensiblement dans un plan parmi au moins deux plans horizontaux espacés en sens vertical, pour permettre de supporter l'extrémité frontale de la carte à circuits dans un plan choisi parmi lesdits plans horizontaux ; et
en ce que le montage de ladite carte à circuits inclut d'abaisser ladite extrémité frontale de la carte à circuits sur lesdites surfaces de support de carte et de recevoir lesdits doigts dans lesdits trous de la carte à circuits.
